# EUROPEAN PATENT APPLICATION

(11) **EP 4 776 774 A1**
(43) Date of publication of application: **15.07.2026**
(21) Application number: 26150889.9
(22) Date of filing: 08.01.2026
(51) Int. Cl.: H05K 7/20

(54) **POWER CONVERSION SYSTEM AND ENERGY STORAGE SYSTEM**

(30) Priority: 10.01.2025 CN 202510045013
(71) Applicant: Huawei Technologies Co., Ltd., Shenzhen, Guangdong 518129 (CN)
(72) Inventor: HAO, Yuwei, Shenzhen, 518129 (CN); QIAN, Bin, Shenzhen, 518129 (CN); LI, Jiyang, Shenzhen, 518129 (CN)
(74) Representative: Gill Jennings & Every LLP

(57) **Abstract**

This application provides a power conversion system and an energy storage system, and relates to the field of energy storage technologies. The power conversion system includes an enclosure, a cold plate, a fan, a radiator, and a blocking component. The fan, the radiator, and the blocking component are located in the enclosure. The cold plate is mounted on a chassis of the enclosure, and the radiator is in contact with the cold plate. The fan, the radiator, and the blocking component partition the enclosure into a first heat dissipation cavity and a second heat dissipation cavity. An air outlet of the fan is located in the first heat dissipation cavity, an air inlet of the radiator is located in the first heat dissipation cavity, and an air outlet of the radiator is located in the second heat dissipation cavity. The fan is configured to drive air in the first heat dissipation cavity to enter the radiator through the air inlet of the radiator and enter the second heat dissipation cavity through the air outlet of the radiator. The power conversion system in the foregoing design provided in this application can effectively improve a heat dissipation condition in a cavity of the enclosure, thereby improving heat dissipation performance of the entire power conversion system, and improving running reliability of the power conversion system.

## Description

### TECHNICAL FIELD

This application relates to the field of energy storage technologies, and in particular, to a power conversion system and an energy storage system.

### BACKGROUND

In an energy storage scenario, a power conversion system (power conversion system, PCS) may be configured to: convert a direct current output by a battery pack into an alternating current and output the alternating current to a power grid, or convert an alternating current from a power grid into a direct current and input the direct current to a battery pack. Therefore, the PCS plays an important role in voltage, current, and power conversion in the energy storage scenario.

As energy density of an energy storage system is increased, a requirement on a power output of the PCS is increasingly high. As a result, heat generated by the PCS during running is sharply increased. In this case, the heat generated by the PCS needs to be dissipated in time, to ensure that the PCS can safely and efficiently run.

### SUMMARY

This application provides a power conversion system and an energy storage system, to improve a heat dissipation condition in a cavity of the power conversion system, thereby improving heat dissipation performance of the power conversion system, and improving running stability of the energy storage system.

According to a first aspect, this application provides a power conversion system. The power conversion system includes an enclosure, a cold plate, a fan, a radiator, and a blocking component. The fan, the radiator, and the blocking component are located in the enclosure. The cold plate is mounted on a chassis of the enclosure, and the radiator is in contact with the cold plate. The fan, the radiator, and the blocking component partition the enclosure into a first heat dissipation cavity and a second heat dissipation cavity. An air outlet of the fan is located in the first heat dissipation cavity. An air inlet of the radiator is located in the first heat dissipation cavity, and an air outlet of the radiator is located in the second heat dissipation cavity. The fan can be configured to drive air in the first heat dissipation cavity to enter the radiator through the air inlet of the radiator and enter the second heat dissipation cavity through the air outlet of the radiator. According to the heat dissipation solution of the power conversion system provided in this application, air flowing through the radiator can be cooled by cooling the radiator by the cold plate, to effectively reduce an overall temperature of air in the enclosure of the power conversion system, and improve a heat dissipation condition of each component in the enclosure. This can improve heat dissipation performance of the power conversion system, helps improve running safety of the component, and helps increase power density of the power conversion system.

In a possible implementation of this application, the power conversion system further includes a first-type component and a second-type component, the first-type component is disposed in the first heat dissipation cavity, and the second-type component is disposed in the second heat dissipation cavity. When the power conversion system normally operates, heat generated by the first-type component per unit time is greater than heat generated by the second-type component per unit time. In this way, heat dissipation for the first-type component can be implemented through high-speed flowing of air at the air outlet of the fan, to ensure safe running of the first-type component. In addition, low-temperature air obtained after heat exchange with the radiator may be used to cool the second-type component, to meet a heat dissipation requirement of the second-type component.

In a possible implementation of this application, the cold plate includes a coolant flow channel, the coolant flow channel is configured for flowing of a coolant, and the coolant is used to exchange heat with the first-type component, the second-type component, and the radiator. In addition, the coolant sequentially flows in the coolant flow channel through positions corresponding to the radiator, the first-type component, and the second-type component. In other words, in this application, compared with the first-type component and the second-type component, the radiator is located upstream of a flowing direction of the coolant in the coolant flow channel. In this way, the radiator can be effectively cooled via the coolant with a relatively low temperature in the cold plate.

In this application, the enclosure includes a top wall and a bottom wall that are disposed opposite to each other, and the cold plate is mounted on the bottom wall. A spacing between the blocking component and the top wall is less than a spacing between the radiator and the top wall. In this way, under blocking effect of the blocking component, air in a cavity of the enclosure directionally flows. This helps improve uniformity of airflow in the cavity of the enclosure and avoid a hot spot in the cavity.

In addition, the blocking component includes a radiator air shroud, a part of the radiator air shroud is located in the first heat dissipation cavity, and the other part of the radiator air shroud is located in the second heat dissipation cavity. In addition, the radiator air shroud covers the radiator in a direction from the top wall to the bottom wall. In this way, the radiator air shroud can converge the air flowing through the radiator. This facilitates full contact for heat exchange between the air and the radiator, thereby increasing utilization of a cold source of the radiator.

In a possible implementation of this application, the radiator air shroud includes a first port and a second port in a direction from the air outlet of the radiator to the air inlet of the radiator, a projection of the first port covers a projection of the second port, and a projection area of the first port is greater than a projection area of the second port. In this way, the radiator air shroud can converge air entering the radiator, to improve efficiency of heat exchange between the air and the radiator. In addition, this helps increase a coverage area of air with a relatively low temperature blown out from the air outlet of the radiator in the second heat dissipation cavity, to help improve uniformity of a temperature in the second heat dissipation cavity and avoid a local hot spot.

In a possible implementation of this application, the spacing between the blocking component and the top wall is less than or equal to a minimum distance between the air outlet of the fan and the top wall. In this way, the blocking component can block air in the first heat dissipation cavity and air in the second heat dissipation cavity, so that most of the air in the first heat dissipation cavity can flow to the radiator under driving of the fan. This helps improve efficiency of heat exchange between the air in the chassis of the enclosure and the radiator.

In a possible implementation of this application, the blocking component further includes a first baffle plate and a second baffle plate, the first baffle plate is located between the second baffle plate and the radiator, and a projection of the second baffle plate covers at least a part of a projection of the radiator in the direction from the air outlet of the radiator to the air inlet of the radiator. In addition, the chassis of the enclosure further includes a side wall, the side wall is located between the top wall and the bottom wall, the first baffle plate, the second baffle plate, the radiator, and the side wall enclose the second heat dissipation cavity, the second baffle plate, the fan, and the side wall enclose a third heat dissipation cavity, the third heat dissipation cavity communicates with the second heat dissipation cavity, and the air inlet of the fan is located in the third heat dissipation cavity. In this way, air cooled by the radiator can flow along a directional path from the second heat dissipation cavity to the third heat dissipation cavity. This helps improve uniformity of a temperature in the enclosure, and helps reduce a high temperature point in the enclosure of the power conversion system, to improve the heat dissipation condition of each component in the enclosure of the power conversion system.

In a possible implementation of this application, the second baffle plate includes a first end and a second end, and the first end is closer to the fan than the second end. A distance between the second end and the side wall of the enclosure is less than or equal to half of a distance between the first end and the side wall of the enclosure in a direction from the first end to the second end. In this way, under blocking effect of the second baffle plate, air flowing to the second heat dissipation cavity through the radiator may enter the third heat dissipation cavity through a gap between the second end of the second baffle plate and the side wall. This helps increase a flowing range of the air entering the third heat dissipation cavity, to help reduce the high temperature point in the enclosure of the power conversion system.

In this application, a spacing between the second baffle plate and the top wall is less than or equal to a minimum distance between the air inlet of the fan and the top wall. Under the blocking effect of the second baffle plate, the air in the third heat dissipation cavity can directionally flow to the air inlet of the fan, to improve efficiency of air circulation in the enclosure.

In a possible implementation of this application, the power conversion system further includes a third-type component, and the third-type component is disposed in the third heat dissipation cavity. When the power conversion system normally operates, an allowable ambient temperature of the third-type component is lower than an allowable ambient temperature of the first-type component. Because the air entering the third heat dissipation cavity has been cooled by the radiator, an ambient temperature in the third heat dissipation cavity is relatively low, and therefore, a running requirement of the third-type component can be met.

Specific types of various components are not limited in this application. For example, the first-type component includes at least one of a relay or an inductor, and the second-type component includes at least one of a thin-film capacitor or a control chip.

In a possible implementation of this application, the radiator includes a plurality of sub-radiators, a thermal interface material layer is disposed between the plurality of sub-radiators and the cold plate, and the plurality of sub-radiators are connected to the cold plate via bolts. This helps control flatness between each sub-radiator and the cold plate, to improve tightness of attaching between the radiator and the cold plate via the thermal interface material layer, and improve efficiency of heat exchange between the radiator and the cold plate.

In a possible implementation of this application, the radiator includes a pipeline, the pipeline communicates with the coolant flow channel of the cold plate, and the pipeline and the coolant flow channel are configured for flowing of the coolant. In this way, heat exchange with the air in the cavity of the enclosure can be implemented through flowing of the coolant in the pipeline of the radiator. This can effectively reduce thermal resistance from the coolant to the air in the cavity of the enclosure, and further improve efficiency of cooling the air in the cavity by the radiator.

In addition, the radiator further includes a heat dissipation fin, and the heat dissipation fin is connected to an outer wall surface of the pipeline. This further increases an area of heat exchange between the radiator and the air in the cavity, and helps reduce an ambient temperature in the cavity of the enclosure of the power conversion system, to improve the heat dissipation condition of each component in the enclosure.

According to a second aspect, this application further provides an energy storage system. The energy storage system includes a battery pack, a liquid cooling system, and the power conversion system in the first aspect. The power conversion system is configured to: convert an alternating current into a direct current and provide the direct current to the battery pack for storage, or convert a direct current from the battery pack into an alternating current for output. The liquid cooling system is configured to provide the coolant to the cold plate. In the energy storage system provided in this application, the power conversion system has relatively good heat dissipation performance. This helps improve running stability of the energy storage system.

### BRIEF DESCRIPTION OF DRAWINGS

FIG. 1 is a diagram of a three-dimensional structure of a power conversion system according to an embodiment of this application;
FIG. 2 is a diagram of a three-dimensional structure of a power conversion system according to an embodiment of this application;
FIG. 3 is a top view of the power conversion system provided in FIG. 2;
FIG. 4 is a diagram of another structure of a power conversion system according to an embodiment of this application;
FIG. 5 is a top view of a power conversion system according to an embodiment of this application;
FIG. 6 is a diagram of another structure of a power conversion system according to an embodiment of this application;
FIG. 7 is a diagram of a distribution manner of components on a cold plate according to an embodiment of this application;
FIG. 8 is a diagram of a structure of a coolant flow channel design of a cold plate according to an embodiment of this application;
FIG. 9 is a diagram of a structure of a radiator according to an embodiment of this application;
FIG. 10 is a diagram of another structure of a power conversion system according to an embodiment of this application;
FIG. 11 is a diagram of another structure of a radiator according to an embodiment of this application;
FIG. 12 is a diagram of a structure of a heat dissipation fin according to an embodiment of this application; and
FIG. 13 is an enlarged view of a partial structure of the radiator in FIG. 11 at A.

### Reference numerals:

1000: energy storage system; 100: cabinet; 200: battery pack; 300: power conversion system; 400: liquid cooling system;
1: enclosure; 101: sheet metal chassis; 1011: side wall; 1012: bottom wall; 11: first heat dissipation cavity; 12: second heat dissipation cavity; 13: third heat dissipation cavity;
2: cold plate; 21: coolant flow channel; 3: fan; 31: air outlet of the fan; 32: air inlet of the fan; 33: housing of the fan; 4: radiator;
41: air inlet of the radiator; 42: air outlet of the radiator; 44: pipeline; 45: heat dissipation fin;
5: blocking component; 51: first baffle plate; 52: radiator air shroud; 521: first port; 522: second port; 53: second baffle plate;
531: first end; 532: second end; 61: first-type component; 62: second-type component; 63: third-type component; 71: first circuit board;
72: second circuit board; 73: third circuit board; 74: fourth circuit board; and 8: partition plate.

### DESCRIPTION OF EMBODIMENTS

To make objectives, technical solutions, and advantages of this application clearer, the following further describes this application in detail with reference to accompanying drawings. However, example implementations can be implemented in a plurality of forms, and should not be construed as being limited to implementations described herein. Same reference numerals in the figures indicate same or similar structures. Therefore, repeated descriptions thereof are omitted. Expressions of positions and directions in embodiments of this application are described by using the accompanying drawings as an example. However, changes may be also made as required, and all the changes fall within the protection scope of this application. The accompanying drawings in embodiments of this application are merely used to illustrate relative position relationships and do not represent an actual scale.

It should be noted that specific details are set forth in the following descriptions for ease of understanding this application. However, this application can be implemented in a plurality of manners different from those described herein, and a person skilled in the art can perform similar promotion without departing from the connotation of this application. Therefore, this application is not limited to the specific implementations disclosed below.

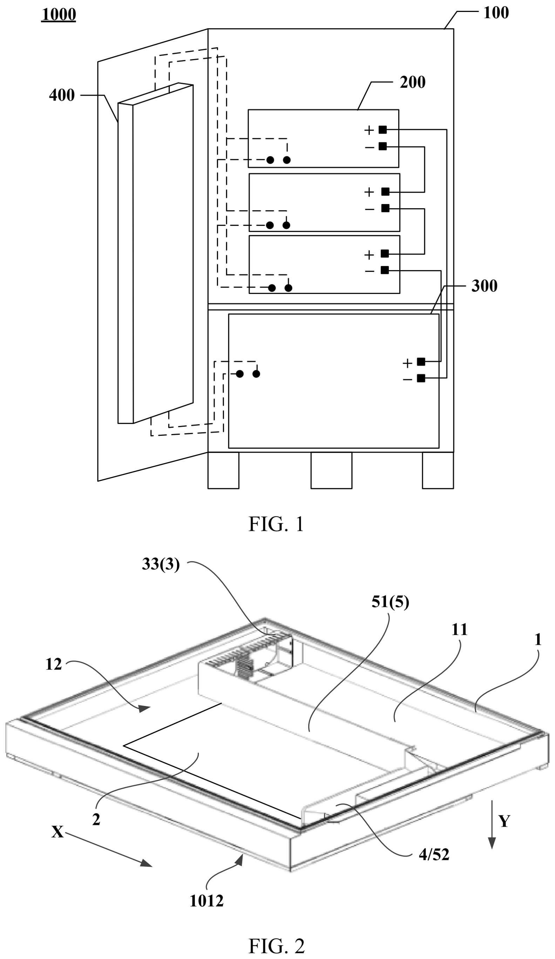

For ease of understanding a power conversion system provided in this application, the following first describes an application scenario of the power conversion system. The power conversion system may be used in an energy storage system. FIG. 1 is a diagram of an architecture of an energy storage system according to an embodiment of this application. The energy storage system 1000 may include a cabinet 100, a battery pack 200, and a power conversion system 300. Both the battery pack 200 and the power conversion system 300 may be accommodated in the cabinet 100. The battery pack 200 is a basic unit for the energy storage system 1000 to implement electric energy storage and release. The power conversion system 300 may be configured to convert an alternating current into a direct current and then provide the direct current to the battery pack 200 for storage, or may be configured to convert a direct current from the battery pack 200 into an alternating current for output.

To implement a power conversion function, a plurality of power electronic devices, such as a power module, an inductor, an electrolytic capacitor, or a relay, are usually disposed in an enclosure of the power conversion system 300. A large amount of heat is generated when these power electronic devices operate. If the heat cannot be dissipated from these power electronic devices in time, temperatures of the power electronic devices may exceed an allowable temperature. Consequently, performance of the power electronic devices is affected. In a severe case, normal use of the power conversion system 300 is affected, and normal running of the energy storage system 1000 is affected.

In an existing heat dissipation solution for the power conversion system 300, as shown in FIG. 1, the energy storage system 1000 may further include a liquid cooling system 400. The liquid cooling system 400 is configured to provide a coolant to a cold plate in the power conversion system 300. Heat dissipation for components that generate a large amount of heat, such as a power module and an inductor in the enclosure of the power conversion system 300 can be implemented by attaching a housing to the cold plate, and heat dissipation effect is relatively good. Heat dissipation for other components in the enclosure of the power conversion system 300 is implemented via a fan through circulating turbulence of air in the enclosure. However, because heat dissipation in the enclosure is implemented only through heat exchange between a wall surface of the enclosure and the outside, a heat dissipation capability is low, and an overall temperature of the air in the enclosure remains relatively high. As a result, reliability of the components for which heat dissipation is implemented through circulating turbulence of the air in the enclosure is threatened.

In view of this, in the power conversion system provided in embodiments of this application, a radiator that can cool air is disposed in the enclosure, to reduce an overall temperature of the air in a cavity of the enclosure, and improve a heat dissipation condition of each component in the enclosure of the power conversion system, thereby improving heat dissipation performance of the power conversion system. The following describes in detail the power conversion system provided in embodiments of this application with reference to accompanying drawings.

FIG. 2 is a diagram of a three-dimensional structure of a power conversion system according to an embodiment of this application. The power conversion system includes an enclosure 1, a cold plate 2, a fan 3, a radiator 4, and a blocking component 5. The cold plate 2 is mounted on a chassis of the enclosure 1. In specific implementation, the chassis of the enclosure 1 includes a mounting hole, the cold plate 2 is mounted in the mounting hole, and the cold plate 2 is fastened to the chassis of the enclosure 1. A connection manner may be but is not limited to soldering. In this way, the cold plate 2 and the chassis of the enclosure 1 jointly enclose a cavity of the enclosure 1.

In actual application, the enclosure 1 may include a sheet metal chassis 101 and a cover plate. The sheet metal chassis 101 may include a plurality of side walls 1011 that are sequentially connected to each other and a bottom wall 1012. The cover plate covers the sheet metal chassis 101 in a direction facing the bottom wall 1012. In other words, the cover plate is disposed opposite to the bottom wall 1012, and the cover plate may be used as a top wall of the enclosure 1. It should be noted that, for ease of displaying the structure of the power conversion system, the cover plate is omitted in FIG. 2. Based on this, it may be understood that the mounting hole may be, for example, disposed in the bottom wall 1012 of the sheet metal chassis 101. The cold plate 2, the sheet metal chassis 101, and the cover plate jointly form the chassis of the enclosure 1.

It can be learned from the foregoing description of the structure of the chassis of the enclosure 1 that, in this application, the top wall and the bottom wall 1012 of the enclosure 1 are disposed opposite to each other, and the side wall is located between the top wall and the bottom wall 1012.

Still refer to FIG. 2. The fan 3, the radiator 4, and the blocking component 5 are all located in the enclosure 1, and the fan 3, the radiator 4, and the blocking component 5 separate the enclosure 1 into a first heat dissipation cavity 11 and a second heat dissipation cavity 12.

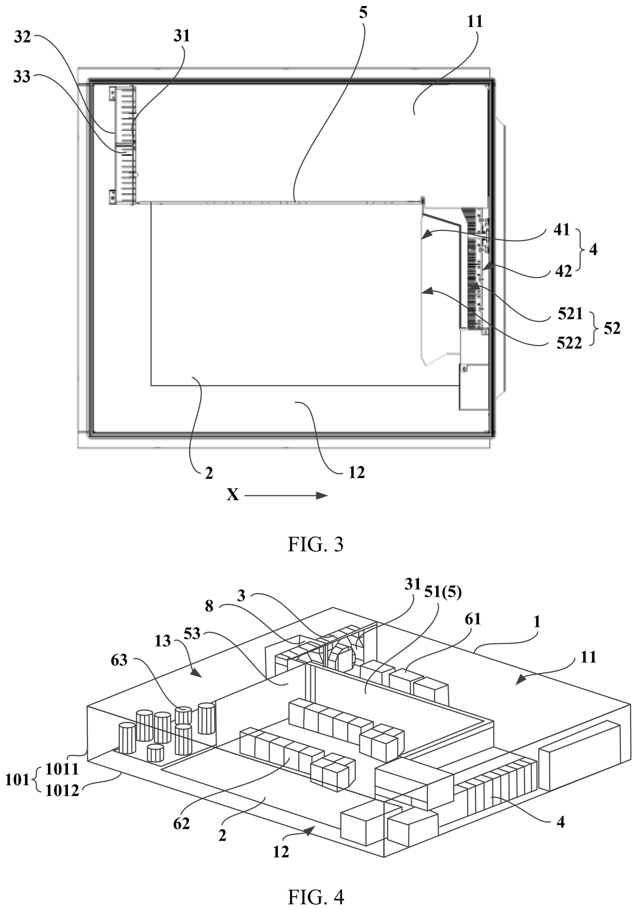

In addition, FIG. 3 is a top view of the power conversion system provided in FIG. 2. In this application, an air outlet 31 of the fan is located in the first heat dissipation cavity 11, an air inlet 41 of the radiator is located in the first heat dissipation cavity 11, and an air outlet 42 of the radiator is located in the second heat dissipation cavity 12. In this application, the fan 3 may be configured to drive air in the first heat dissipation cavity 11 to enter the radiator 4 through the air inlet 41 of the radiator, exchange heat with the radiator 4, and then enter the second heat dissipation cavity 12 through the air outlet 42 of the radiator.

Because the cold plate 2 can implement heat dissipation for a component through flowing of a coolant, in this embodiment of this application, the radiator 4 is in contact with the cold plate 2, to implement heat exchange between the radiator 4 and the cold plate 2, so that the radiator 4 can be cooled via the cold plate 2. In this way, the air in the first heat dissipation cavity 11 is cooled when entering the radiator 4; and the cooled air enters the second heat dissipation cavity 12, and then is blown out to the first heat dissipation cavity 11 via the fan 3, to implement circulation of the air in the enclosure 1.

It can be understood that, according to the heat dissipation solution provided in this application, air flowing through the radiator 4 can be cooled by cooling the radiator 4 by the cold plate 2, to effectively reduce an overall temperature of the air in the enclosure 1 of the power conversion system, and improve a heat dissipation condition of each component in the enclosure 1. This helps improve running safety of the component, and helps increase power density of the power conversion system.

As mentioned above, the fan 3, the radiator 4, and the blocking component 5 partition the enclosure 1 into the first heat dissipation cavity 11 and the second heat dissipation cavity 12. When the fan 3, the radiator 4, and the blocking component 5 are specifically disposed, the blocking component 5 may include a plurality of members. For example, still refer to FIG. 2. In this embodiment, the blocking component 5 includes a first baffle plate 51, the first baffle plate 51 is connected to a housing 33 of the fan, and the first baffle plate 51 extends to the radiator 4, so that the fan 3, the first baffle plate 51, and the radiator 4 jointly partition the enclosure 1 into the first heat dissipation cavity 11 and the second heat dissipation cavity 12.

Still refer to FIG. 2. In this application, a part of the first baffle plate 51 may be located on a side that is of the radiator 4 and that is close to the top wall. In this way, most of the air in the first heat dissipation cavity 11 may enter the second heat dissipation cavity 12 through the radiator 4 under driving of the fan 3. This helps improve efficiency of heat exchange between air in the enclosure 1 and the radiator 4.

In addition, as shown in FIG. 2, in this embodiment, a spacing between the first baffle plate 51 and the top wall is less than or equal to a spacing between the air outlet 31 of the fan and the top wall. In this way, the first baffle plate 51 can block the air in the first heat dissipation cavity 11 and the second heat dissipation cavity 12, so that most of the air in the first heat dissipation cavity 11 can flow to the radiator 4 under driving of the fan 3.

In actual application, the fan 3 may be placed on the bottom wall, and the blocking component 5 may be connected to the bottom wall 1012. In this case, a height of the blocking component 5 may be greater than a height of the fan 3 in a direction from the top wall to the bottom wall 1012, namely, a Y direction in FIG. 2, so that a spacing between the entire blocking component 5 and the top wall is less than or equal to a minimum distance between the air outlet 31 of the fan and the top wall, to improve blocking effect of the blocking component 5.

Still refer to FIG. 2, the blocking component 5 may further include a radiator air shroud 52. As shown in FIG. 3, a part of the radiator air shroud 52 is located in the first heat dissipation cavity 11, and the other part of the radiator air shroud 52 is located in the second heat dissipation cavity 12. In addition, the radiator air shroud 52 covers the radiator 4 in the direction from the top wall to the bottom wall, namely, the Y direction shown in FIG. 2. In addition, the part, located on the side that is of the radiator 4 and that is close to the top wall, of the first baffle plate 51 may be located on a side that is of the radiator air shroud 52 and that is close to the top wall. In this way, the radiator air shroud 52 can converge the air flowing through the radiator 4. This facilitates full contact for heat exchange between the air and the radiator 4, thereby increasing utilization of a cold source of the radiator 4.

In addition, still refer to FIG. 3. The radiator air shroud 52 includes a first port 521 and a second port 522 in a direction from the air outlet 42 of the radiator to the air inlet 41 of the radiator, namely, an X direction in FIG. 3. A projection of the first port 521 covers a projection of the second port 522 in the X direction, and a projection area of the first port 521 is greater than a projection area of the second port 522. In this way, the radiator air shroud 52 can converge air entering the radiator 4, to improve efficiency of heat exchange between the air and the radiator 4. In addition, this helps increase a coverage area of air with a relatively low temperature blown out from the air outlet 42 of the radiator in the second heat dissipation cavity 12, to help improve uniformity of a temperature in the second heat dissipation cavity 12 and avoid a local hot spot.

It should be noted that, in a possible embodiment of this application, a projection area of the air outlet 42 of the radiator may be greater than a projection area of the air inlet 41 of the radiator in the direction from the air outlet 42 of the radiator to the air inlet 41 of the radiator, so that the air inlet 41 of the radiator can converge the air entering the radiator 4 from the first heat dissipation cavity 11, and the air cooled by the radiator 4 has relatively large coverage when being blown out from the air outlet 42 of the radiator, to improve a heat dissipation environment of the component in the enclosure 1.

It may be understood that, in this application, the spacing between the entire blocking component 5 and the top wall may be less than a spacing between the radiator 4 and the top wall. This can implement directional flowing of air in the cavity of the enclosure 1, to help improve uniformity of airflow in the cavity of the enclosure 1 and avoid a hot spot in the cavity.

As described above, the power conversion system further includes a plurality of components, and the plurality of components are accommodated in the enclosure 1. The plurality of components may be arranged in the enclosure 1 based on heat dissipation requirements of the components, to effectively dissipate heat from the plurality of components. For example, FIG. 4 is a diagram of another structure of the power conversion system according to this embodiment of this application. In this embodiment of this application, the plurality of components may include a first-type component 61 and a second-type component 62. When the power conversion system normally operates, heat generated by the first-type component 61 is greater than heat generated by the second-type component 62. Considering that an air speed at the air outlet 31 of the fan is relatively high, efficiency of heat exchange between airflow at the air outlet and the component is relatively high. Therefore, in this application, the first-type component 61 may be disposed in the first heat dissipation cavity 11, to dissipate heat from the first-type component 61 through high-speed air flowing, thereby ensuring safe running of the first-type component 61. In addition, the second-type component 62 is disposed in the second heat dissipation cavity 12, so that low-temperature air obtained after heat exchange with the radiator 4 can be used to cool the second-type component 62.

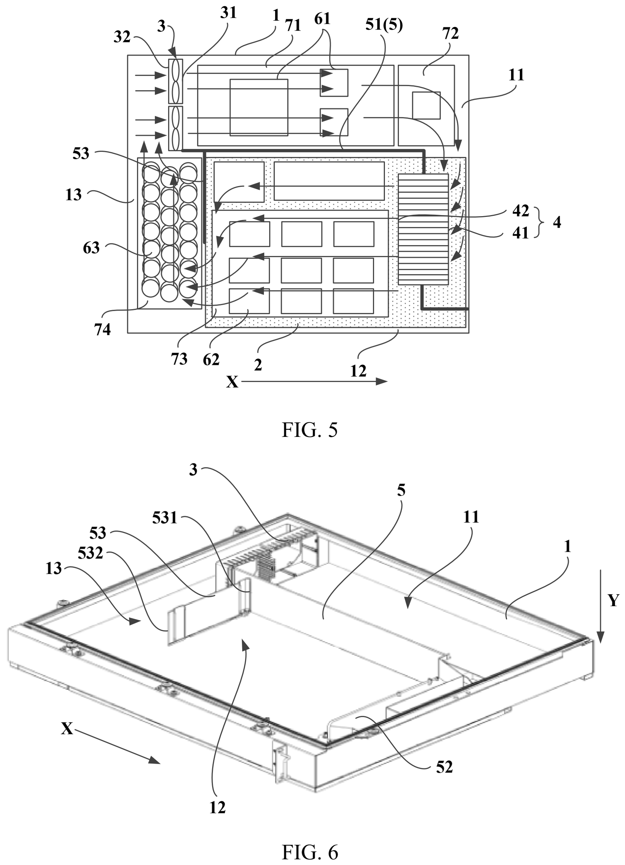

It can be understood that each component in the power conversion system may be disposed on a corresponding circuit board. For example, FIG. 5 is a top view of the power conversion system according to this embodiment of this application. In this application, the power conversion system further includes a first circuit board 71, a second circuit board 72, and a third circuit board 73. Some first-type components 61 are disposed on the first circuit board 71, and the other first-type components 61 are disposed on the second circuit board 72. The first circuit board 71 and the second circuit board 72 are also disposed in the first heat dissipation cavity 11. Similarly, the second-type component 62 is disposed on the third circuit board 73, and the third circuit board 73 may be disposed in the second heat dissipation cavity 12.

Still refer to FIG. 4 and FIG. 5. In this embodiment of this application, the blocking component 5 further includes a second baffle plate 53, and the first baffle plate 51 is located between the second baffle plate 53 and the radiator 4. A projection of the second baffle plate 53 covers at least a part of a projection of the radiator 4 in the direction from the air outlet 42 of the radiator to the air inlet 41 of the radiator, namely, the X direction.

In this application, as shown in FIG. 5, the first baffle plate 51, the second baffle plate 53, the radiator 4, and the side wall of the chassis of the enclosure 1 enclose the second heat dissipation cavity 12, and the second baffle plate 53, the fan 3, and the side wall of the chassis of the enclosure 1 enclose the third heat dissipation cavity 13. The third heat dissipation cavity 13 communicates with the second heat dissipation cavity 12, and an air inlet 32 of the fan is located in the third heat dissipation cavity 13. In this way, the air cooled by the radiator 4 may enter the third heat dissipation cavity 13 after flowing through the second heat dissipation cavity 12, to dissipate heat from the component in the third heat dissipation cavity 13.

It should be noted that a quantity of fans 3 is not limited in this application. For example, there may be one fan or at least two fans. For example, in the foregoing embodiment, there are two fans 3. In addition, in the embodiment shown in FIG. 4, air inlets of the two fans 3 are spaced apart via a partition plate 8. This helps improve air intake uniformity of the two fans 3, further helps increase air exhaust volume of the two fans 3, and helps improve efficiency of air circulation in the enclosure 1.

FIG. 6 is a diagram of another structure of the power conversion system according to this embodiment of this application. Refer to FIG. 6. In this embodiment, the second baffle plate 53 includes a first end 531 and a second end 532. The first end 531 is closer to the fan 3 than the second end 532, and a distance between the second end 532 and the enclosure 1 is less than or equal to half of a distance between the first end 531 to the side wall of the enclosure 1 in a direction from the first end 531 to the second end 532. In this way, under blocking effect of the second baffle plate, the air with the relatively low temperature blown out from the air outlet 42 of the radiator can enter the third heat dissipation cavity 13 through a gap between the second end 532 of the second baffle plate 53 and the side wall, and then enter the fan 3. This helps increase a flowing range of the air entering the third heat dissipation cavity 13, to help reduce a high temperature point of the enclosure 1 of the power conversion system, and helps improve uniformity of a temperature in the enclosure 1, to improve the heat dissipation condition of each component in the enclosure 1 of the power conversion system.

It may be understood from the above description that, in this application, a spacing between the second baffle plate 53 and the top wall is less than or equal to a minimum distance between the air inlet 32 of the fan and the top wall. Under the blocking effect of the second baffle plate 53, the air in the third heat dissipation cavity 13 can directionally flow to the air inlet 32 of the fan, to improve efficiency of air circulation in the enclosure 1.

It should be noted that, in this application, a part or all of the blocking component 5 may include an original structure in the power conversion system, for example, housings of some components with relatively large sizes in a direction from the bottom wall 1012 to the top wall. This helps simplify a structure design of the power conversion system, and helps reduce a weight of the power conversion system. In some other embodiments, a part or all of the blocking component 5 may alternatively be of a structure independent of an original structure in the power conversion system. This helps improve flexibility of disposing the blocking component 5, helps optimize an airflow channel formed in the cavity of the enclosure 1, thereby improving heat dissipation effect of the cavity of the enclosure 1.

It can be learned from the above description that, in the enclosure 1 of the power conversion system provided in this application, a temperature of air obtained after heat exchange with the radiator 4 is relatively low. In other words, temperatures of air in the second heat dissipation cavity 12 and air in the third heat dissipation cavity 13 are relatively low. Therefore, in this embodiment of this application, still refer to FIG. 4 and FIG. 5. The power conversion system may further include a third-type component 63. When the power conversion system normally operates, if an allowable ambient temperature of the third-type component 63 is lower than an allowable ambient temperature of the first-type component 61, the third-type component 63 is disposed in the third heat dissipation cavity 13. In actual application, the third-type component 63 may include at least one of an electrolytic capacitor or a control chip.

It should be noted that, in this application, the allowable ambient temperature is a range of an ambient temperature that can be borne by the component when the power conversion system normally operates.

In addition, as shown in FIG. 5, the power conversion system may further include a fourth circuit board 74, and the third-type component 63 may be disposed on the fourth circuit board 74. The fourth circuit board 74 may be disposed in the third heat dissipation cavity 13, so that the fourth circuit board 74 is in an environment with a relatively low temperature.

In this application, various components that have different heat dissipation condition requirements are disposed in different cavities, so that thermal interference between the various components can be reduced while effective heat dissipation is implemented for the various components, and proper utilization of space in the enclosure 1 of the power conversion system is facilitated.

The first-type component 61 and the second-type component 62 are not specifically limited in this application. For example, the first-type component 61 includes at least one of a relay or an inductor, and the second-type component 62 includes at least one of a thin-film capacitor or a control chip.

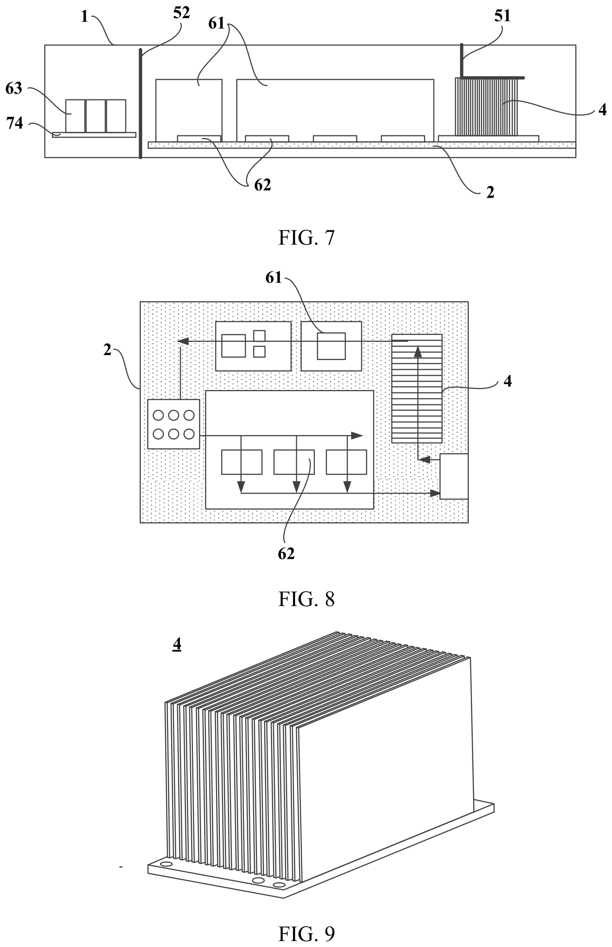

FIG. 7 is a diagram of a distribution manner of components on the cold plate according to this embodiment of this application. In this application, the cold plate 2 includes a coolant flow channel, the coolant flow channel is configured for flowing of a coolant, and the coolant may be used to exchange heat with the first-type component 61, the second-type component 62, and the radiator 4.

Considering that heat dissipation requirements of components that exchange heat with the cold plate 2 may be different, when the coolant flow channel of the cold plate 2 is designed, a flowing direction of the coolant in the coolant flow channel and a width of each part of the coolant flow channel may be adjusted based on distribution, on the cold plate 2, of the components having the different heat dissipation requirements. In addition, for components with high power consumption, such as a power module and an inductor, a structure like a turbulence fin may be disposed in the coolant flow channel, to improve efficiency of heat exchange between the component and the cold plate 2 through turbulence of the coolant.

Moreover, because the coolant needs to exchange heat with the component when flowing in the coolant flow channel, it can be understood that a temperature of the coolant upstream of the coolant flow channel is lower than a temperature of the coolant downstream. Therefore, in a possible embodiment of this application, FIG. 8 is a diagram of a structure of a coolant flow channel design of the cold plate according to this embodiment of this application. Arrows in FIG. 8 may represent a flowing direction of the coolant in the coolant flow channel. It can be seen that, in this application, the coolant sequentially flows in the coolant flow channel through positions corresponding to the radiator 4, the first-type component 61, and the second-type component 62. In other words, compared with the first-type component 61 and the second-type component 62, the radiator 4 is located upstream of the flowing direction of the coolant in the coolant flow channel. In this case, the radiator 4 can be effectively cooled via the coolant with a relatively low temperature in the cold plate 2.

A specific disposing manner of the radiator 4 is not limited in this application. For example, in a possible embodiment, the radiator 4 may be a skived fin radiator shown in FIG. 9. The radiator 4 may be connected to the cold plate 2 via a fastener like a bolt, to implement heat exchange with the cold plate 2. In addition, a thermal interface material layer like silicone grease or gel may be further disposed between the radiator 4 and the cold plate 2, to improve efficiency of heat exchange between the radiator 4 and the cold plate 2.

In addition, in a possible embodiment of this application, the radiator 4 may include a plurality of sub-radiators, a thermal interface material layer is disposed between each of the plurality of sub-radiators and the cold plate 2, and the plurality of sub-radiators are connected to the cold plate 2 via bolts. This helps dispose the radiator 4, and helps control flatness between each sub-radiator and the cold plate 2, to improve tightness of attaching between the radiator 4 and the cold plate 2 via the thermal interface material layer, and improve efficiency of heat exchange between the radiator 4 and the cold plate 2.

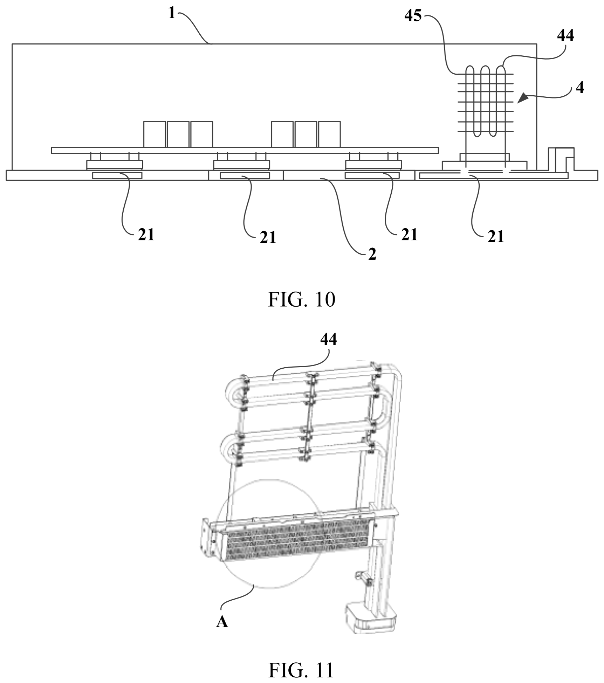

FIG. 10 is a diagram of another structure of the power conversion system according to this embodiment of this application. In the embodiment shown in FIG. 10, the radiator 4 includes a pipeline 44, and the pipeline 44 communicates with the coolant flow channel 21 of the cold plate 2, so that the pipeline 44 and the coolant flow channel 21 are jointly used for flowing of the coolant. In this way, heat exchange with air in the cavity of the enclosure 1 can be implemented through flowing of the coolant in the pipeline 44 of the radiator 4. This can effectively reduce thermal resistance from the coolant to the air in the cavity of the enclosure 1, and further improve efficiency of cooling the air in the cavity by the radiator 4.

Still refer to FIG. 10. When the pipeline 44 of the radiator 4 is specifically connected to the cold plate 2, an opening of the pipeline 44 is soldered to the cold plate 2 through an interface on the cold plate 2, so that the pipeline 44 communicates with the coolant flow channel 21 of the cold plate 2. It can be learned from the foregoing description that the radiator 4 is located upstream of the flowing direction of the coolant in the coolant flow channel 21. Therefore, in this embodiment, the opening of the pipeline 44 may communicate with an upstream position of the coolant flow channel 21. In this way, a coolant with a relatively low temperature that enters from a liquid inlet of the cold plate 2 can first flow through the pipeline 44, and then flow along the coolant flow channel 21. This can help reduce a temperature of the pipeline 44 of the radiator 4, to reduce a temperature of the air in the cavity of the enclosure 1 of the power conversion system.

In this application, the pipeline 44 of the radiator 4 may be but is not limited to a serpentine pipe shown in FIG. 11, or may be disposed in another form. For example, the radiator 4 may be a parallel flow radiator. In other words, the pipeline 44 of the radiator 4 includes a plurality of parallel pipes disposed side by side. This helps increase an area of heat exchange between the pipeline 44 and the air in the cavity.

In addition, refer to FIG. 10. The radiator 4 may further include a heat dissipation fin 45, and the heat dissipation fin 45 is connected to an outer wall surface of the pipeline 44. In actual application, an end part of the heat dissipation fin 45 is connected to the outer wall surface of the pipeline 44, and another part of the heat dissipation fin protrudes from the outer wall surface of the pipeline 44. This helps increase an area of heat exchange between the radiator 4 and the air in the cavity.

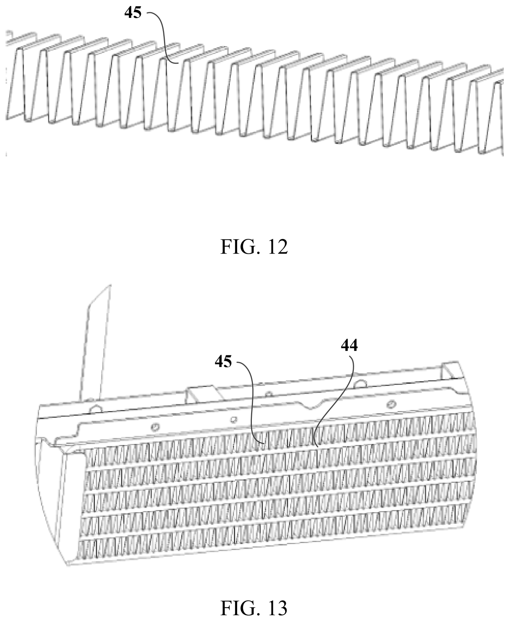

When the heat dissipation fin 45 is specifically disposed, FIG. 12 is a diagram of a structure of the heat dissipation fin according to this embodiment of this application. In this embodiment, a plurality of heat dissipation fins 45 are connected end to end to form a wavy structure, or the heat dissipation fin 45 is of a wavy structure formed by bending a same plate-shaped structure. In another possible embodiment of this application, the heat dissipation fins 45 may alternatively be disposed in another possible manner. For example, a plurality of heat dissipation fins 45 are spaced apart side by side. Details are not listed one by one herein. However, it should be understood that they all fall within the protection scope of this application.

FIG. 13 is an enlarged view of a partial structure of the radiator provided in FIG. 11 at A. The radiator 4 includes the pipeline 44 and the heat dissipation fins 45 shown in FIG. 12. As shown in FIG. 13, the heat dissipation fins 45 may be disposed in gaps formed between outer wall surfaces of the pipeline 44. This helps increase a contact area between the heat dissipation fins 45 and the outer wall surfaces of the pipeline 44, to improve efficiency of heat exchange between the heat dissipation fins 45 and the coolant in the pipeline 44, so as to improve efficiency of heat exchange between the radiator 4 and the air in the cavity of the enclosure 1.

In conclusion, it may be understood that, according to the heat dissipation solution of the power conversion system provided in this application, heat may be dissipated from the radiator 4 in the enclosure 1 via the cold plate 2, to cool the air flowing through the radiator 4. This can effectively reduce an overall temperature in the cavity of the enclosure 1, to improve the heat dissipation condition of the component in the enclosure 1, thereby improving running reliability of the power conversion system.

In addition, in the foregoing embodiments, an application of the heat dissipation solution provided in this application in the power conversion system is used as an example for description. The heat dissipation solution may be further applied to power conversion devices in various fields such as inverters, vehicle-mounted power supplies, vehicle-mounted motor control units (motor control unit, MCU), or site blade power supplies. For a specific disposing manner, refer to the foregoing embodiment. Details are not described herein again.

It should be noted that, in embodiments of this application, unless otherwise stated or there is a logic conflict, terms and/or descriptions in different embodiments are consistent and may be mutually referenced, and technical features in different embodiments may be combined based on an internal logical relationship thereof, to form a new embodiment.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power conversion system, comprising an enclosure, a cold plate, a fan, a radiator, and a blocking component, wherein the fan, the radiator, and the blocking component are located in the enclosure;
the cold plate is mounted on a chassis of the enclosure, and the radiator is in contact with the cold plate; and
the fan, the radiator, and the blocking component partition the enclosure into a first heat dissipation cavity and a second heat dissipation cavity, an air outlet of the fan is located in the first heat dissipation cavity, an air inlet of the radiator is located in the first heat dissipation cavity, an air outlet of the radiator is located in the second heat dissipation cavity, and the fan is configured to drive air in the first heat dissipation cavity to enter the radiator through the air inlet of the radiator and enter the second heat dissipation cavity through the air outlet of the radiator.

2. The power conversion system according to claim 1, wherein the power conversion system further comprises a first-type component and a second-type component, the first-type component is disposed in the first heat dissipation cavity, the second-type component is disposed in the second heat dissipation cavity, and when the power conversion system normally operates, heat generated by the first-type component per unit time is greater than heat generated by the second-type component per unit time.

3. The power conversion system according to claim 2, wherein the cold plate comprises a coolant flow channel, the coolant flow channel is configured for flowing of a coolant, the coolant is used to exchange heat with the first-type component, the second-type component, and the radiator, and the coolant sequentially flows in the coolant flow channel through positions corresponding to the radiator, the first-type component, and the second-type device.

4. The power conversion system according to claim 2 or 3, wherein the chassis of the enclosure comprises a top wall and a bottom wall that are disposed opposite to each other, the cold plate is mounted on the bottom wall, and a spacing between the blocking component and the top wall is less than a spacing between the radiator and the top wall.

5. The power conversion system according to claim 4, wherein the blocking component comprises a radiator air shroud, a part of the radiator air shroud is located in the first heat dissipation cavity, the other part of the radiator air shroud is located in the second heat dissipation cavity, and the radiator air shroud covers the radiator in a direction from the top wall to the bottom wall.

6. The power conversion system according to claim 5, wherein the radiator air shroud comprises a first port and a second port in a direction from the air outlet of the radiator to the air inlet of the radiator, a projection of the first port covers a projection of the second port, and a projection area of the first port is greater than a projection area of the second port.

7. The power conversion system according to claim 5 or 6, wherein the spacing between the blocking component and the top wall is less than or equal to a minimum distance between the air outlet of the fan and the top wall.

8. The power conversion system according to any one of claims 5 to 7, wherein the blocking component further comprises a first baffle plate and a second baffle plate, the first baffle plate is located between the second baffle plate and the radiator, and a projection of the second baffle plate covers at least a part of a projection of the radiator in the direction from the air outlet of the radiator to the air inlet of the radiator; and
the chassis of the enclosure further comprises a side wall, the side wall is located between the top wall and the bottom wall, the first baffle plate, the second baffle plate, the radiator, and the side wall enclose the second heat dissipation cavity, the second baffle plate, the fan, and the side wall enclose a third heat dissipation cavity, the third heat dissipation cavity communicates with the second heat dissipation cavity, and the air inlet of the fan is located in the third heat dissipation cavity.

9. The power conversion system according to claim 8, wherein the second baffle plate comprises a first end and a second end, the first end is closer to the fan than the second end, and a distance between the second end and the side wall of the enclosure is less than or equal to half of a distance between the first end and the side wall of the enclosure in a direction from the first end to the second end.

10. The power conversion system according to claim 8 or 9, wherein a spacing between the second baffle plate and the top wall is less than or equal to a minimum distance between the air inlet of the fan and the top wall.

11. The power conversion system according to any one of claims 8 to 10, wherein the power conversion system further comprises a third-type component, the third-type component is disposed in the third heat dissipation cavity, and when the power conversion system normally operates, an allowable ambient temperature of the third-type component is lower than an allowable ambient temperature of the first-type component.

12. The power conversion system according to any one of claims 1 to 11, wherein the radiator comprises a plurality of sub-radiators, a thermal interface material layer is disposed between the plurality of sub-radiators and the cold plate, and the plurality of sub-radiators are connected to the cold plate via bolts.

13. The power conversion system according to any one of claims 1 to 11, wherein the radiator comprises a pipeline, the pipeline communicates with the coolant flow channel of the cold plate, and the pipeline and the coolant flow channel are configured for flowing of the coolant.

14. The power conversion system according to claim 13, wherein the radiator further comprises a heat dissipation fin, and the heat dissipation fin is connected to an outer wall surface of the pipeline.

15. An energy storage system, wherein the energy storage system comprises a battery pack, a liquid cooling system, and the power conversion system according to any one of claims 1 to 14; the power conversion system is configured to: convert an alternating current into a direct current and provide the direct current to the battery pack for storage, or configured to convert a direct current from the battery pack into an alternating current for output; and the liquid cooling system is configured to provide the coolant to the cold plate.
